# DEMANDE DE BREVET EUROPEEN

(11) **EP 0 942 460 A1**
(43) Date de publication de la demande: **15.09.1999**
(21) Numéro de dépôt: 99400584.1
(22) Date de dépôt: 10.03.1999
(51) Int. Cl.: H01L 21/285, H01L 21/3205, H01L 21/265

(54) **Procédé de formation d'une couche de siliciure de titane de faible résistivité sur un substrat semiconducteur de silicium et dispositif obtenu**

(30) Priorité: 13.03.1998 FR 9803134
(71) Demandeur: STMicroelectronics SA, 94250 Gentilly Cedex (FR); Koninklijke Philips Electronics N.V., 5621 BA Eindhoven (NL); FRANCE TELECOM, 75015 Paris (FR)
(72) Inventeur: Gerritsen, Eric, 38920 Crolles (FR); Baylac, Bruno, 38190 Brignoud (FR); Basso, Marie-Therese, 38240 Meylan (FR)
(74) Mandataire: Casalonga, Axel

(57) **Abrégé**

Le procédé selon l'invention comprend une étape d'implantation dans ou de dépôt sur la surface d'au moins une zone dopée d'un substrat de silicium d'une quantité effective d'un élément métallique choisi parmi l'indium, le gallium, l'étain et le plomb, une étape de dépôt d'un couche de titane sur la surface d'au moins la zone dopée du substrat de silicium et le recuit thermique rapide du substrat de silicium revêtu de la couche de titane pour former du siliciure de titane de faible résistivité.

Application à la fabrication des dispositifs semiconducteurs, en particulier CMOS.

## Description

La présente invention concerne d'une manière générale un procédé de formation d'une couche de siliciure de titane de faible résistivité à la surface de zones dopées d'un substrat semiconducteur de silicium.

Le siliciure de titane est le siliciure prédominant dans l'industrie des dispositifs microélectroniques intégrés, en particulier dans les technologies VLSI et ULSI.

Le siliciure de titane TiSi₂ est un matériau polymorphique qui peut exister sous une forme orthorhombique base centrée, appelée phase C49, ayant une résistivité élevée de l'ordre de 75 µOhm.cm ou sous une forme orthorhombique face centrée, appelée phase C54 de faible résistivité, de l'ordre de 15µOhm.cm. Lorsqu'un film de titane déposé sur du silicium est chauffé, la phase C49 de résistivité élevée se forme à des températures comprises entre 550 et 700°C et puis se transforme en phase C54 de faible résistivité à des températures supérieures à environ 750°C.

La transformation de la phase C49 en phase C54 est limitée par une énergie d'activation élevée (supérieure à 5,0 eV) dépendant des dopants et de la cristallinité du substrat de silicium et de la dimension de la région à siliciurer.

Expérimentalement, l'énergie d'activation élevée pour la formation de la phase C54 a pour résultat la formation d'une très faible densité de germes C54 dans une matrice de phase C49 pendant un recuit thermique.

Avec la diminution des largeurs de lignes, 0,30µm et moins, il est devenu de plus en plus difficile d'utiliser un recuit thermique pour transformer une structure de la phase C49 de résistivité élevée en phase C54 de faible résistivité du fait d'un manque de germes C54.

Ceci a pour résultat que les films de TiSi₂ siliciure de titane sont, soit encore sous forme de phase C49 soit se composent d'un mélange de phases C49 et C54, et par conséquent ont une résistivité plus élevée que si on obtenait une transformation complète en phase C54. Cette résistivité élevée du siliciure de titane peut diminuer la performance du dispositif semiconducteur tel que par exemple un dispositif CMOS.

Pour remédier à cet inconvénient, on a proposé d'implanter ou de déposer à la surface du substrat de silicium des atomes de métal réfractaire en particulier de molybdène ou de tungstène avant de déposer la couche de titane et de former le siliciure de titane par recuit thermique rapide.

Ainsi, l'article intitulé "Reduction of the C54 - TiSi₂ phase transformation temperature using refactory metal ion implantation", R.W. MANN, et al. Appl. Phys. Lett. 67 (25), 18 décembre 1995 décrit l'implantation d'ions de métal réfractaire, en particulier de tungstène ou de molybdène, sur un substrat de silicium suivi du dépôt d'une mince couche de titane et enfin d'un traitement thermique rapide pour former le siliciure de titane ayant une faible résistivité.

L'article "TiSi₂ phase transformation characteristics on narrow devices", Glen L. MILES et al, Thin Solid films 290-291 (1996) 469-472 décrit que la présence de petites quantités de molybdène pendant la formation de siliciure accroit le taux de noyaux précurseurs de phase C54 et précise que le molybdène peut agir comme un catalyseur et qu'il n'est pas nécessaire qu'il y ait un mélange à l'interface ou la création d'une couche de silicium amorphe pour améliorer la germination.

Il a été également proposé d'utiliser d'autres métaux réfractaires tels que le tantale et le niobium.

L'utilisation de molybdène pour favoriser la transformation de la phase C49 en phase C54 dans le siliciure de titane est également décrite dans les articles "Salicides for 0.10 µm Gate Lengths : A comparative study of One- Step RTP Ti with Mo doping, Ti with pre-amorphization and Co Processes" JORGE A. KITTL et al., 1997 Symposium on VLSI Technology Digest of technical Papers et "Novel One-Step RTP Ti Salicide Process with low sheet resistance 0.06 µm Gates and high drive current", JORGE A. KITTL, et al IEDM 97-111 à 114.

Bien que le dopage au moyen des métaux réfractaires tels le molybdène et le tungstène améliore la transformation de la phase C49 en phase C54 du siliciure de titane, l'emploi de métaux réfractaires, en particulier du molybdène, présente des inconvénients. En effet, le molybdène et le tungstène forment avec le silicium des composés très stables ce qui nuira à la formation du siliciure de titane. En outre, l'implantation de molybdène ou tungstène n'est pas souhaitable en raison de problèmes de contamination croisée (cross-contamination) de l'élément implanté.

L'article "Sub-Quarter Micron Titanium Salicide Technology with in-situ silicidation using high-temperature sputtering", Kuinihiro FUJII et al. 1995 Symposium on VLSI Technology Digest of Technical Papers décrit la pré-amorphisation de la surface d'un substrat de silicium par implantation d'arsenic en vue de favoriser la transformation de la phase C49 en phase C54 du siliciure de titane.

Toutefois, ce procédé donne lieu à des fuites aux jonctions, principalement dans les dispositifs NMOS et l'effet sur la résistivité du siliciure est relativement modéré.

L'invention a donc pour objet de fournir un procédé de formation d'une couche de siliciure de titane de faible résistivité qui remédie aux inconvénients des procédés de l'art antérieur.

Selon l'invention, on fournit un procédé de formation d'une couche de siliciure de titane de faible résistivité sur une surface d'au moins une zone dopée d'un substrat semiconducteur de silicium comportant une étape de dépôt d'une couche de titane sur la surface d'au moins ladite zone dopée du substrat et une étape de recuit thermique rapide du substrat revêtu de la couche de titane pour former du siliciure de titane qui se caractérise par le fait que préalablement à l'étape de recuit, on effectue une étape d'implantation ou de dépôt d'une quantité effective d'un élément métallique choisi parmi l'indium (In), le gallium (Ga), l'étain (Sn) et le plomb (Pb) à l'interface entre la couche de titane et au moins ladite zone dopée du substrat semiconducteur de silicium.

De préférence, l'élément métallique est choisi parmi l'indium et le gallium, et tout particulièrement l'élément métallique est l'indium.

La quantité effective d'élément métallique est toute quantité suffisante pour promouvoir la transformation de la phase C49 du siliciure de titane en phase C54 lors du recuit thermique rapide ultérieur. De préférence, la quantité effective d'élément métallique est comprise entre 1.10¹³ et 5.10¹⁴ atomes/cm², mieux entre 5.10¹³ et 5.10¹⁴ atomes/cm² et mieux encore entre 5.10¹³ et 3.10¹⁴ atomes/cm².

L'introduction de l'élément métallique à l'interface entre la ou les zone(s) dopée(s) du substrat de silicium et la couche de titane peut s'effectuer par implantation de l'élément métallique dans la ou les zone(s) dopée(s) du substrat de silicium ou par dépôt sur la surface de la ou des zone(s) dopée(s) du substrat de silicium, avant le dépôt de la couche de titane. En variante, l'élément métallique peut être introduit après dépôt de la couche de titane par diffusion ou par implantation à travers la couche de titane. L'élément métallique peut également simplement être intégré dans l'alliage de la cible utilisée pour le dépôt par pulvérisation de la couche de titane. Le procédé recommandé est l'implantation de l'élément métallique dans la ou les zone(s) dopée(s) du substrat de silicium avant dépôt de la couche de titane. La profondeur d'implantation de l'élément métallique est généralement. comprise entre 5 et 25 nm, de préférence 8 à 20 nm.

On peut utiliser tout procédé d'implantation classique. En général l'énergie d'implantation de l'élément métallique est comprise entre 5 et 30 keV, de préférence cette énergie est de 25 keV environ.

En particulier l'implantation peut s'effectuer par implantation par faisceau d'ions classique.

Ainsi, il est possible d'implanter une dose de 3.10¹⁴ In/cm² à partir d'une cible-source de InCl₃ solide chauffée à 320°C avec une énergie d'implantation de 25 keV.

Le dépôt de la couche de titane peut se faire par tout procédé de dépôt classique tel que par exemple un dépôt physique en phase vapeur (PVD).

A titre d'exemple, il est possible de déposer par PVD, une couche de titane de 30nm en quinze secondes environ.

Le recuit thermique pour la formation du siliciure de titane peut se faire par tout procédé de recuit classique, tel qu'un recuit à 760°C pendant 20 secondes.

L'invention concerne également un dispositif semiconducteur comprenant une couche de siliciure de titane sur une surface d'au moins une zone dopée d'un substrat de silicium, caractérisé en ce qu'il comprend 0,5 à 5 ‰ atomes d'un élément choisi parmi l'indium, le gallium, l'étain et le plomb à l'interface entre le siliciure de titane et la zone dopée du substrat.

De préférence, l'élément est l'indium ou le gallium et mieux est l'indium.

De préférence, les zones dopées du substrat sont les régions de source et de drain d'un dispositif CMOS.

La suite de la description se réfère aux figures annexées qui représentent respectivement :
figures 1a à 1e, une représentation schématique des étapes principales d'un procédé de fabrication d'un semiconducteur NMOS incluant un procédé de formation d'une couche de siliciure de titane selon l'invention ;
figure 2, un graphe comparant la résistance surfacique d'un dispositif NMOS obtenu en utilisant le procédé de la présente invention avec des dispositifs NMOS obtenus par un procédé standard, sans implantation, et des dispositifs NMOS obtenus en utilisant un procédé d'implantation d'ions arsenic de l'art antérieur ;
figure 3, un graphe comparant le courant de fuite de jonction dans un dispositif NMOS obtenu par le procédé de l'invention et des dipositifs NMOS standard et ayant subi l'implantation d'ions arsenic;
figure 4, un graphe comparant la résistance surfacique d'un dispositif PMOS obtenu par le procédé de l'invention avec des dispositifs PMOS standard et ayant subi une implantation d'arsenic ;
figures 5 et 6, des graphes comparant la résistance de contact de dispositifs NMOS et PMOS selon l'invention avec des dispositifs standard et ayant subi une implantation d'arsenic ;
figure 7, un graphe comparant la résistance surfacique d'un dispositif NMOS dopé avec un taux de 4.10¹⁵ atomes de phospore/cm² obtenu par le procédé de l'invention et un dispositif NMOS identique obtenu par un procédé standard ; et
figure 8, un graphe montrant l'effet de la température du recuit de formation du siliciure de titane sur la résistance surfacique obtenue par le procédé selon l'invention et par un procédé standard.

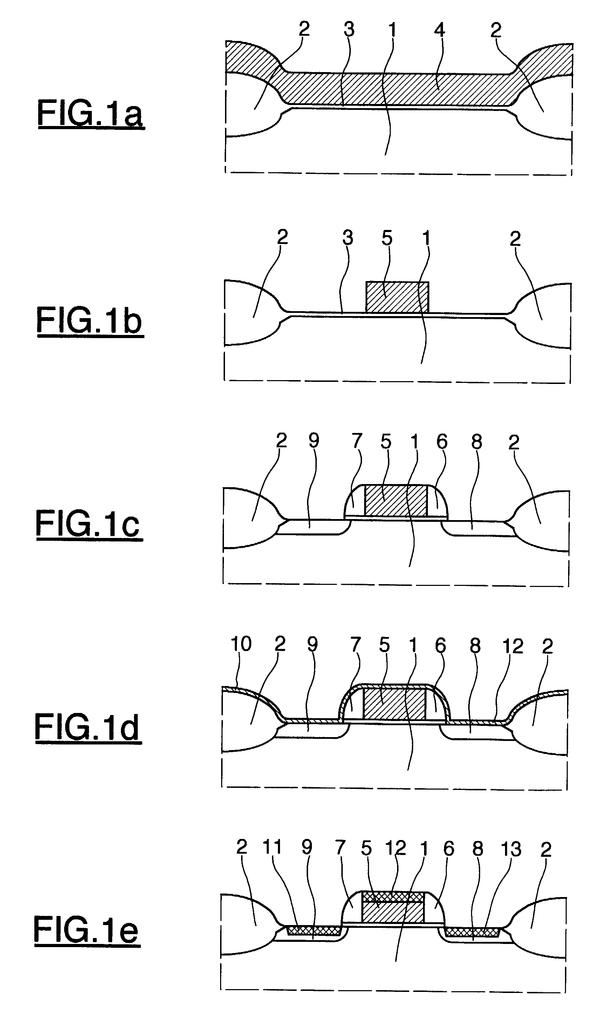

En se référant aux figures 1a à 1e, on va maintenant décrire les étapes principales d'un procédé de fabrication d'un dispositif NMOS ou PMOS incluant le procédé de formation d'une couche de siliciure de titane de faible résistivité selon l'invention.

Comme le montre la figure 1a, la première étape consiste à former sur une surface d'un substrat de silicium 1 des zones isolantes 2 constituées d'une couche épaisse d'oxyde de silicium et des zones d'oxyde de grille 3 sur lesquelles on dépose, par exemple par dépôt en phase vapeur basse pression, une couche de silicium polycristallin 4.

On forme ensuite, comme le montre la figure 1b, par photolithogravure dans la couche de silicium polycristallin 4, la grille en silicium polycristallin 5. Dans le cadre de la fabrication d'un dispositif NMOS, on peut procéder à un dopage par implantation d'atomes de phosphore afin de réduire l'appauvrissement de la grille en silicium polycristallin.

Comme le montre la figure lc, après formation d'espaceurs 6 et 7, on procède à l'implantation d'arsenic ou bore pour former des zones de source et drain de type N ou P, 8 et 9.

Ces étapes a à c sont des étapes classique et bien connues dans la fabrication des dispositifs semiconducteurs.

Selon l'invention, on procède alors à l'implantation d'atomes d'indium, avant le dépôt d'une couche de titane 10 (figure 1d).

De façon recommandée, cette implantation d'indium s'effectue au moyen d'un faisceau d'ions avec une énergie d'implantation de 25 keV et généralement à température ambiante. La dose implantatée est de préférence de 3.10¹⁴ atomes/cm².

Le dépôt de la couche de titane, d'une épaisseur par exemple de 30nm, se fait de manière classique par dépôt physique en phase vapeur, et éventuellement suivi par un dépôt de TiN classique.

Comme le montre la figure le, le processus s'achève par un recuit thermique rapide classique pour former les contacts en siliciure de titane 11, 12, 13 de faible résistivité (phase C54) puis l'élimination de Ti et TiN n'ayant pas réagi par gravure sélective comme cela est classique.

Le recuit thermique rapide peut être un recuit classique à 760°C et d'une durée de 20 secondes sous azote, mais on a trouvé comme on le décrira ci-après, qu'en utilisant le procédé de l'invention avec introduction d'indium à l'interface, il est possible d'obtenir la formation du siliciure de titane de faible résistivité avec des températures de recuit plus basses.

### Exemple 1 et exemples comparatifs A à E:

On a fabriqué par le procédé décrit ci-dessus, mais sans prédopage avec du phosphore, un dispositif NMOS à canal 0,25µm. Le dispositif NMOS de l'exemple 1 avait subi une implantation d'indium à un taux de 3.10¹⁴ atomes par cm² avec une énergie d'implantation 25 keV. Les dispositifs NMOS comparatifs A à D étaient réalisés suivant l'art antérieur avec une implantation d'arsenic avant le dépôt de la couche de titane et la formation du siliciure de titane. Les doses implantées d'arsenic et les énergies d'implantation sont indiqués ci-après :
exemple comparatif A : 1.10¹⁴ atomes par cm² - 10keV
exemple comparatif B : 1.10¹⁴ atomes par cm² - 20keV
exemple comparatif C : 3.10¹⁴ atomes par cm² - 10keV
exemple comparatif D : 3.10¹⁴ atomes par cm² - 20keV

L'exemple comparatif E est un dispositif NMOS standard c'est-à-dire sans aucune implantation avant le dépôt de la couche de titane et la formation du siliciure.

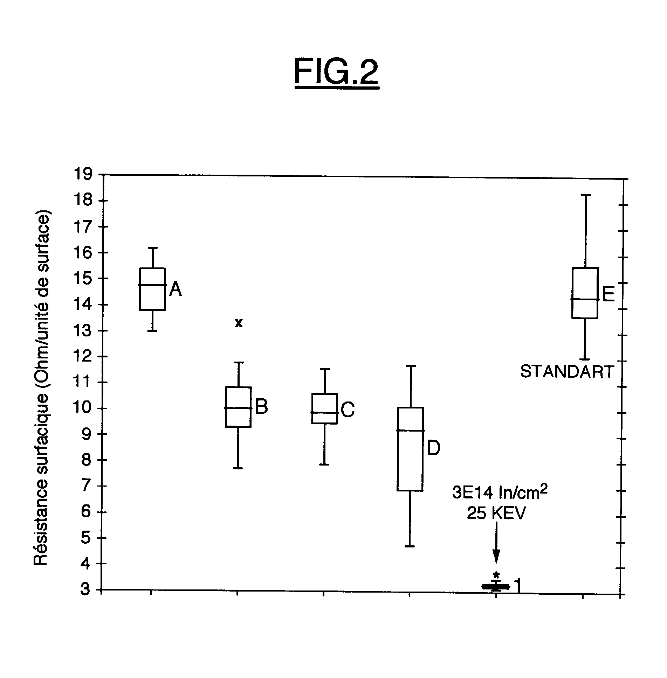

La figure 2 montre la résistance surfacique des différents dispositifs obtenus. On voit immédiatement que le dispositif NMOS obtenu dans le procédé de l'invention présente une résistance surfacique nettement inférieure à celle des dispositifs de l'art antérieur.

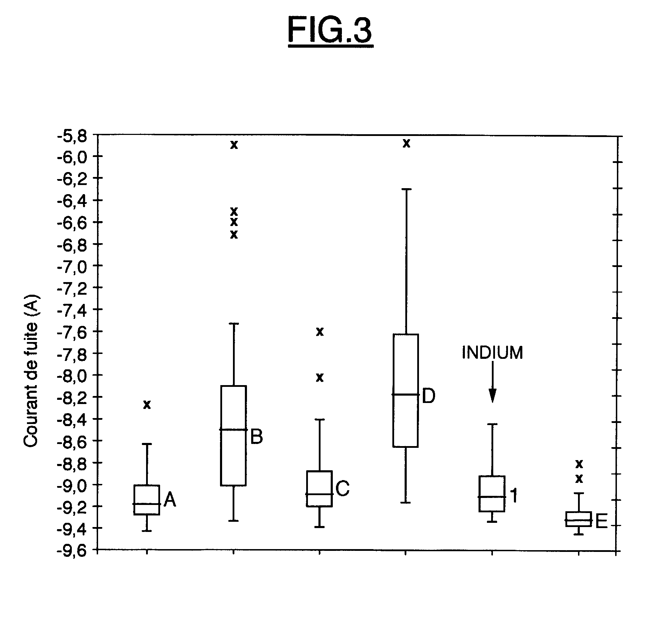

On a représenté sur la figure 3 le courant de fuite de ces dispositifs. Le graphe montre que le dispositif de l'exemple 1 selon l'invention ne présente pas de courant de fuite.

### Exemple 2 et exemples comparatifs F à J

On a réalisé des dispositifs PMOS comme indiqué précédemment pour les dispositifs NMOS mais en remplaçant l'arsenic par du bore pour former des régions de source et de drain de conductivité P.

Les implantations ultérieures d'atomes d'arsenic pour les exemples comparatifs F à I correspondent respectivement aux implantations réalisées pour les exemples A à D précédents. L'exemple comparatif J est un dispositif standard n'ayant subi aucune implantation.

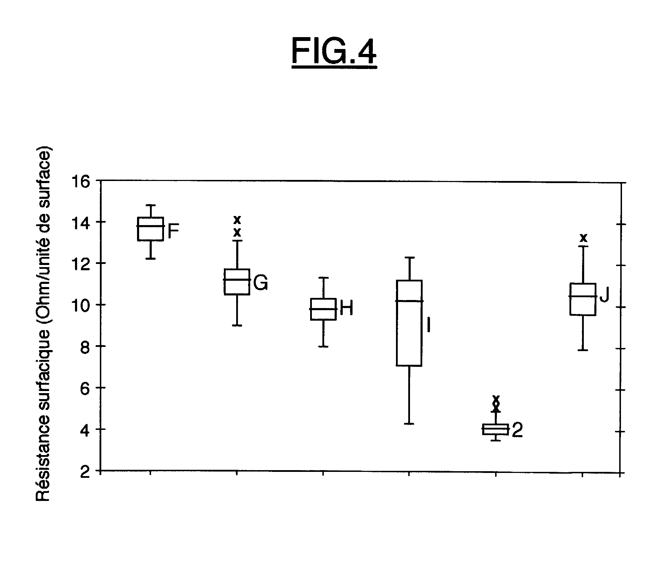

La figure 4 montre la résistance surfacique des différents dispositifs obtenus. On voit que le dispositif PMOS de l'exemple 2 a une résistance nettement inférieure aux dispositifs F à J.

De façon surprenante on constate que dans le cas du dispositif PMOS de l'exemple 2 obtenu par le procédé de l'invention, la résistance est supérieure à celle du dispositif NMOS comparable de l'exemple 1. En effet, dans tous les procédés de siliciuration classiques connus, la résistance du siliciure est généralement toujours plus élevée dans les dispositifs NMOS que dans les dispositifs PMOS.

Bien que l'on ne veuille pas être lié par une théorie quelconque, on suppose que ce résultat est dû au fait que l'indium se combine très aisément à l'arsenic, ce qui empêche l'arsenic de pénétrer dans le titane et évite ainsi la formation de composés entre le titane et l'arsenic qui, dans les procédés classiques, diminue la formation de TiSi₂. Au contraire, l'indium ne forme pas de composé avec le bore et par conséquent ne change pas l'effet de la pénétration du bore dans le titane sur la formation du siliciure.

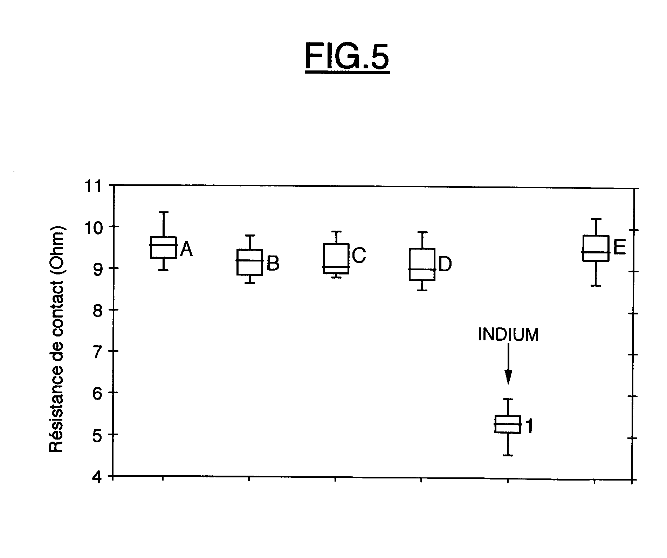

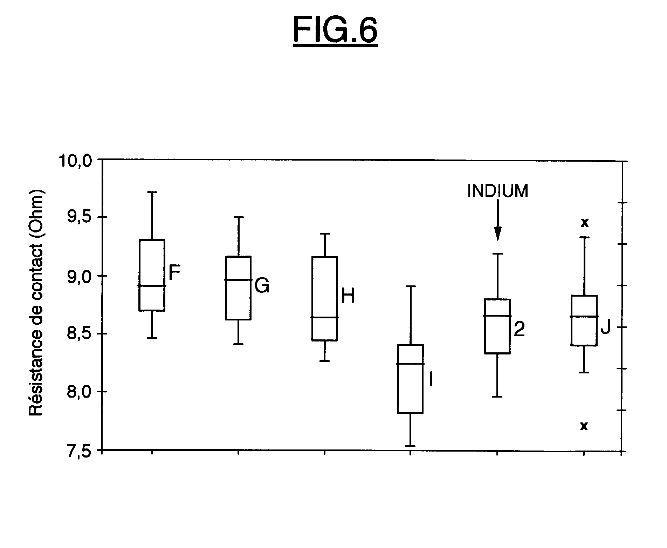

On a également mesuré la résistance de contact des dispositifs des exemples 1 et 2 et des exemples comparatifs A à J. Les résultats sont donnés dans les graphes des figures 5 et 6. Ces figures montrent que dans le cas des dispositifs PMOS, la résistance de contact du dispositif de l'exemple 2 est comparable à celle d'un dispositif standard et légèrement supérieure à celle du meilleur dispositif comportant une implantation d'arsenic. Par contre, dans le cas du dispositif NMOS, le dispositif de l'exemple 1 selon l'invention présente une résistance de contact beaucoup plus faible que les dispositifs des exemples comparatifs, standard E et avec implantation d'arsenic A à D.

### Exemple 3 et exemple comparatif K :

On a fabriqué un dispositif 3 par le procédé selon l'invention et un dispositif K par un procédé standard sans implantation, comme précédemment, mais en effectuant une étape de dopage du polysilicium par implantation d'atomes de phosphore à une dose de 4.10¹⁵ atomes par cm² à 25keV

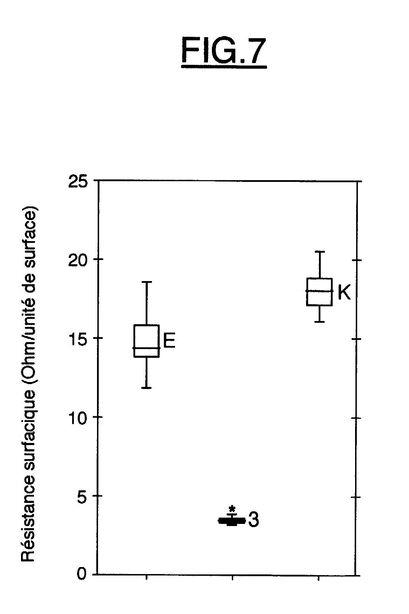

On a mesuré la résistance surfacique des dispositifs NMOS obtenus et on a reporté les résultats sur la figure 7.

Comme le montre la figure 7, le dispositif prédopé K obtenu par le procédé standard a une résistance accrue par rapport à un dispositif E (figure 2) obtenu par le procédé standard mais sans dopage additionel avec du phosphore. Au contraire le dispositif 3 (NMOS) obtenu par le procédé de l'invention et avec le dopage additionel avec du phosphore présente une résistance surfacique encore nettement inférieure au dispositif E.

### Exemple 4:

On a déposé sur des tranches de silicium monocristallines une couche de 40nm de titane et une couche de 25nm de nitrure de titane. Certaines des tranches (repérées par In) avaient subi préalablement au dépôt une implantation d'indium selon l'invention à une énergie d'implantation de 25keV et un taux d'implantation de 10¹⁴ atomes/cm². D'autres tranches (repérées par l'indication Ref.) n'ont pas été soumises à l'implantation d'indium. On a ensuite soumis les tranches obtenues à un recuit thermique rapide à différentes températures. On a mesuré la résistance surfacique du siliciure de titane obtenu.

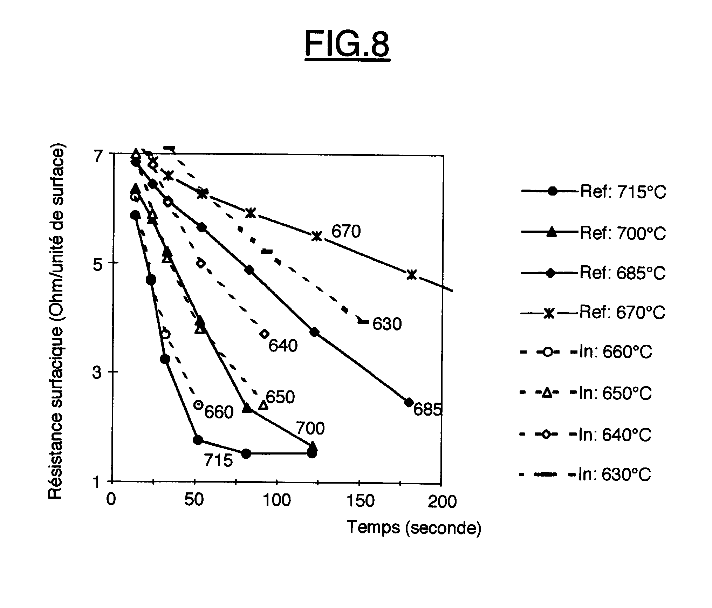

Comme le montre la figure 8, avec le procédé d'implantation d'indium de l'invention, la formation de siliciure s'effectue à des températures qui peuvent être de 50°C inférieures à celles nécessaires pour l'obtention de la résistance surfacique voulue lorsque la tranche n'a pas été soumise à une étape d'implantation d'indium.

## Revendications

1. Procédé de formation d'une couche de siliciure de titane de faible résistivité sur une surface d'au moins une zone dopée d'un substrat semiconducteur de silicium comportant une étape de dépôt d'une couche de titane sur la surface d'au moins ladite zone dopée du substrat semiconducteur de silicium et une étape de recuit thermique rapide du substrat revêtu de la couche de titane pour former du siliciure de titane, caractérisé en ce qu'il comprend, préalablement à l'étape de recuit, une étape d'implantation ou de dépôt d'une quantité effective d'un élément métallique choisi parmi l'indium, le gallium, l'étain, et le plomb à l'interface entre la couche de titane et au moins ladite zone dopée du substrat semiconducteur de silicium.

2. Procédé selon la revendication 1, caractérisé en ce que l'élément métallique est choisi parmi l'indium et le gallium, de préférence l'indium.

3. Procédé selon la revendication 1 ou 2, caractérisé en ce que la quantité effective d'élément métallique est comprise entre 1.10¹³ et 5.10¹⁴ atomes par cm², de préférence entre 5.10¹³ et 5.10¹⁴ atomes par cm² et mieux entre 5.10¹³ et 3.10¹⁴ atomes par cm².

4. Procédé selon l'une quelconque des revendications 1 à 3, caractérisé en ce que l'élément métallique est implanté dans au moins ladite zone dopée du substrat de silicium ou déposé sur la surface d'au moins ladite zone dopée du substrat de silicium avant le dépôt de la couche de titane.

5. Procédé selon l'une quelconque des revendications 1 à 4, caractérisé en ce que l'élément métallique est implanté dans au moins ladite zone dopée du substrat de silicium jusqu'à une profondeur comprise entre 5 et 25nm, de préférence 8 à 20nm.

6. Procédé selon l'une quelconque des revendications 1 à 5, caractérisé en ce que l'énergie d'implantation de l'élément métallique est comprise entre 5 et 30 keV, de préférence de 25 keV environ.

7. Dispositif semiconducteur comprenant une couche de siliciure de titane de faible résistivité sur une surface d'au moins une zone dopée d'un substrat semiconducteur en silicium, caractérisé en ce qu'il comprend 0,5 à 5‰ atomes choisis parmi l'indium, le gallium, l'étain et le plomb, à l'interface entre la couche de siliciure de titane et ladite zone dopée du substrat.

8. Dispositif selon la revendication 7, caractérisé en ce que l'élément métallique est l'indium ou le gallium, et mieux l'indium.
